# EUROPEAN PATENT APPLICATION

(11) **EP 2 432 122 A2**
(43) Date of publication of application: **21.03.2012**
(21) Application number: 11180400.1
(22) Date of filing: 07.09.2011
(51) Int. Cl.: H03H 9/02, H03H 9/145, H03H 9/64

(54) **Elastic wave device**

(30) Priority: 17.09.2010 JP 2010209855
(71) Applicant: Nihon Dempa Kogyo Co., Ltd., Shibuya-ku Tokyo 151-8569 (JP)
(72) Inventor: Yoshimoto, Susumu, Sayama-shi, Saitama 350-1321 (JP)
(74) Representative: TBK

(57) **Abstract**

There is provided an elastic wave device that is capable of suppressing deterioration in flatness of a frequency characteristic in a pass frequency band yet has excellent ESD resistance. At positions apart from a crossing area of electrode fingers (12), toward a busbar (11), first float dummy electrodes (16), and a second float dummy electrode (18) are provided between adjacent IDT electrodes (1), and between the IDT electrode (1) and a grating reflector (2) which are adjacent to each other. These float dummy electrodes (16,18) are in a state of electrically floating from other regions, and these float dummy electrodes (16,18) are formed so as to correspond to an arrangement pattern of the electrode fingers (12) in the IDT electrode (1).

## Description

### BACKGROUND OF THE INVENTION

### 1. FIELD OF THE INVENTION

The present invention relates to an elastic wave device including an IDT (Inter-Digital Transducer) electrode.

### 2. DESCRIPTION OF THE RELATED ART

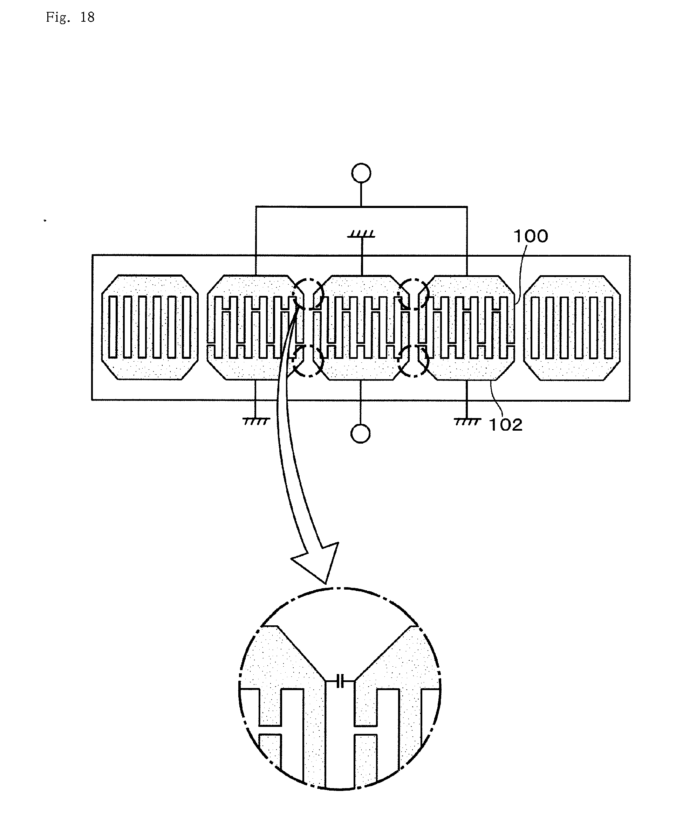

In recent years, as a frequency band used in communication devices such as portable telephone terminals becomes higher, elastic wave devices such as a SAW (Surface Acoustic Wave) filter and a SAW duplexer mounted in the communication devices are required to be adaptable to a higher frequency band. Therefore, in a longitudinal-mode resonant filter shown in Fig. 18, for instance, mounted in this communication device, a gap between electrode fingers 100, 100 in an IDT (Inter-Digital Transducer) electrode 102 has become extremely narrow (a wavelength of a propagating elastic wave has become short).

Such reduction in the separation size between the electrode fingers 100, 100 causes an easy flow of a current between these electrode fingers 100, 100 when a high voltage of ESD (electrostatic discharge) or the like is generated between the adjacent electrode fingers 100, 100. Further, a capacitive component C is generated between regions different in potential, for instance, between the two IDT electrodes 102, 102 as shown in the lower side in Fig. 18, and as the separation size between the IDT electrodes 102, 102 (a wavelength of an elastic wave) becomes smaller, the capacitive component C increases, so that the current easily passes due to the ESD.

Here, a known method to prevent the current passage due to the ESD is, for example, to round edge portions where a current easily flows in the IDT electrode 102, but it is still difficult to prevent an electrostatic discharge damage. Moreover, when in the two IDT electrodes 102, 102, one of the electrode fingers 100, 100 adjacent to each other is removed to cause what is called the separation of the IDT electrodes 102, 102, an area where the elastic wave is not excited is formed, which causes the occurrence of spuriousness (partial increase/decrease of signal intensity) to deteriorate flatness of a frequency characteristic in a pass frequency band.

Patent Document 1 describes an art to enhance ESD resistance between a first busbar 12 and a third busbar 32 by increasing a distance L2 between the first busbar 12 and the third busbar 32 by extending a tip portion 25 of a second electrode finger 24a up to a virtual extension line 18, but it does not discuss ESD between the second electrode finger 24 and the third busbar 32. Further, when a crossing width between the electrode fingers 14, 24 is made shorter than a separation size (aperture length) between the busbars 12, 22 as in Patent Document 1, an elastic wave is excited between the second electrode fingers 24 and fourth dummy electrode fingers 46 adjacent to the second electrode fingers 24, resulting in the occurrence of unnecessary longitudinal-mode spuriousness.

### [Prior Art Document]

### [Patent Document]

[Patent Document 1] Japanese Patent Application Laid-open No. 2009-38718 (paragraphs 0025 to 0026, Fig. 3)

### SUMMARY OF THE INVENTION

The present invention was made under such circumstances and has an object to provide an elastic wave device that is capable of suppressing deterioration in flatness of a frequency characteristic in a pass frequency band yet has excellent ESD resistance.

An elastic wave device of the present invention includes:
a plurality of IDT electrodes arranged apart from each other along a propagation direction of an elastic wave; and grating reflectors sandwiching the plural IDT electrodes from both sides in terms of the propagation direction of the elastic wave, the IDT electrodes and the grating reflectors being formed on a common piezoelectric substrate,
wherein the plural IDT electrodes each include: a pair of busbars connected to one and the other of a signal port and a ground port respectively; and electrode fingers extending in a comb shape from each of the busbars toward the opposite busbar, and an arrangement pattern of the electrode fingers in each of the IDT electrodes and a separation size between the adjacent IDT electrodes are set in order for an arrangement pattern of the electrode fingers in the IDT electrodes to be continuously formed along the propagation direction of the elastic wave,
wherein the grating reflectors each include: a plurality of grating electrode fingers extending along a length direction of the electrode fingers and disposed apart from each other in the propagation direction of the elastic wave; and grating busbars connecting one-side tips and the other-side tips of the grating electrode fingers respectively, and an arrangement of the grating electrode fingers and a separation size of each of the grating reflectors from the adjacent IDT electrode correspond to the arrangement pattern,
wherein, assuming that in one IDT electrode out of the two adjacent IDT electrodes, the electrode finger adjacent to the other IDT electrode is called a first end electrode finger, an end portion closer to the other IDT electrode in the busbar opposite the busbar connected to the first end electrode finger, out of the pair of the busbars of the one IDT electrode, is apart from an extension area of a tip of the first end electrode finger toward the one IDT electrode side,
wherein a first float dummy electrode extending in a direction perpendicular to the propagation direction of the elastic wave is formed in the extension area to prevent an electrostatic discharge damage between regions different in potential between the one IDT electrode and the other IDT electrode, and
wherein a width size of the first float dummy electrode and separation sizes of the first float dummy electrode from the IDT electrodes on both sides of the first float dummy electrode correspond to the arrangement pattern, and the first float dummy electrode is in a state of electrically floating from the plural IDT electrodes, the signal port, the ground port, and the grating reflectors.

The elastic wave device may have the following structures as concrete modes:
A structure in which:
   assuming that in the IDT electrode adjacent to the grating reflector, the electrode finger adjacent to the grating reflector is called a second end electrode finger, an end portion closer to the grating reflector in the busbar opposite the busbar connected to the second end electrode finger, out of the pair of busbars of the adjacent IDT electrode, is apart from an extension area of a tip of the second end electrode finger toward the adjacent IDT electrode side;
   a second float dummy electrode extending in the direction perpendicular to the propagation direction of the elastic wave is formed in the extension area of the second end electrode finger to prevent an electrostatic discharge damage between the grating reflector and the adjacent IDT electrode; and
   a width size of the second float dummy electrode and separation sizes of the second float dummy electrode from the adjacent IDT electrode and from the grating reflector correspond to the arrangement pattern, and the second float dummy electrode is in a state of electrically floating from the plural IDT electrodes, the signal port, the ground port, the grating reflectors, and the first float dummy electrode.

A structure in which the grating busbars, instead of connecting the one-side tips and the other-side tips of the grating electrode fingers, connect the one-side tips and the other-side tips of the grating electrode finger at an end opposite the IDT electrode up to the grating electrode finger next to at least one grating electrode finger on the IDT electrode side, to release both tips of the at least one grating electrode finger from the grating busbars and make the at least one grating electrode finger form a float reflector.

A structure in which:
in each of the plural IDT electrodes, dummy electrode fingers extending from each of the pair of busbars to face tips of the electrode fingers extending from the opposite busbar are provided to make a crossing width smaller than an aperture length in terms of the propagation direction of the elastic wave, the crossing width being a width with which the electrode fingers extending adjacently to each other from one busbar and from the other busbar out of the pair of busbars cross each other, and the aperture length being a size between the pair of busbars; and
the first float dummy electrode is formed to extend from a position close to the tip of the first end electrode finger up to an edge line opposite an edge line to which the electrode fingers are connected in the busbar facing the busbar to which the first end electrode finger is connected, when seen in the propagation direction of the elastic wave. A structure in which the second float dummy electrode is formed to extend from a position close to the tip of the second end electrode finger to the edge line opposite the edge line to which the electrode fingers are connected in the busbar facing the busbar to which the second end electrode finger is connected, when seen in the propagation direction of the elastic wave.

A structure in which:
the busbar to which the signal port is connected in the one IDT electrode and the busbar to which the ground port is connected in the other IDT electrode are disposed in a line along the propagation direction of the elastic wave; and
the first float dummy electrode is provided in an area, of the other IDT electrode, adjacent to the one IDT electrode, in addition to the area, of the one IDT electrode, adjacent to the other IDT electrode.
A structure in which:
   the number of the IDT electrodes is three or more;
   in the IDT electrodes, the busbars to which the signal port is connected and the busbars to which the ground port is connected are alternately disposed in a line along the propagation direction of the elastic wave; and
   as for one IDT electrode and the other IDT electrode adjacent to each other out of the IDT electrodes, in the one IDT electrode, the first float dummy electrode is disposed in an area adjacent to the other IDT electrode, and in the other IDT electrode, the first float dummy electrode is disposed in an area adjacent to the one IDT electrode.
A structure in which the second float dummy electrodes are provided in respective areas between the grating reflectors and the IDT electrodes adjacent to the grating reflectors. A structure in which the float reflectors are provided in the respective areas between the IDT electrodes and the grating reflectors.

An elastic wave device according to another aspect of the present invention includes:
an IDT electrode formed on a piezoelectric substrate and including: a pair of busbars each connected to a signal port or a ground port; and electrode fingers extending in a comb shape from each of the busbars toward the opposite busbar; and
a grating reflector formed on the piezoelectric substrate to be apart from the IDT electrode in a propagation direction of an elastic wave, and including: a plurality of grating electrode fingers extending along a length direction of the electrode fingers and disposed apart from each other in the propagation direction of the elastic wave; and grating busbars connecting one-side tips and the other-side tips of the grating electrode fingers,
wherein, in the IDT electrode and the grating reflector, an arrangement pattern of the electrode fingers, an arrangement pattern of the grating electrode fingers, and a separation size between the IDT electrode and the grating reflector are set in order for an arrangement pattern of the electrode fingers in the IDT electrode to be continuously formed along the propagation direction of the elastic wave,
wherein, assuming that the electrode finger adjacent the grating reflector is called a second end electrode finger, an end portion closer to the grating reflector in the busbar opposite the busbar connected to the second end electrode finger, out of the pair of busbars of the IDT electrode, is apart from an extension area of the second end electrode finger toward the IDT electrode,
wherein a second float dummy electrode extending in a direction perpendicular to the propagation direction of the elastic wave is formed in the extension area to prevent an electrostatic discharge damage between the grating reflector and the IDT electrode, and
wherein a width size of the second float dummy electrode and separation sizes of the second float dummy electrode from the IDT electrode and from the grating reflector correspond to the arrangement pattern, and the second float dummy electrode is in a state of electrically floating from the IDT electrode, the signal port, the ground port, and the grating reflector.

An elastic wave device according to still another aspect of the present invention includes:
an IDT electrode formed on a piezoelectric substrate and including: a pair of busbars each connected to a signal port or a ground port; and electrode fingers extending in a comb shape from each of the busbars toward the opposite busbar; and
a grating reflector formed on the piezoelectric substrate to be apart from the IDT electrode in a propagation direction of an elastic wave, and including: a plurality of grating electrode fingers extending along a length direction of the electrode fingers and disposed apart from each other in the propagation direction of the elastic wave; and grating busbars connecting one-side tips and the other-side tips of at least the grating electrode finger located second from an IDT electrode-side end up to the grating electrode finger at an end portion opposite the IDT electrode,
wherein, in the IDT electrode and the grating reflector, an arrangement pattern of the electrode fingers, an arrangement pattern of the grating electrode fingers, and a separation size between the IDT electrode and the grating reflector are set in order for an arrangement pattern of the electrode fingers in the IDT electrode to be continuously formed along the propagation direction of the elastic wave, and
wherein the grating electrode finger disposed apart from the grating busbar is in a state of electrically floating from the IDT electrode, the signal port, the ground port, and other regions of the grating reflector.

### EFFECT OF THE INVENTION

In the present invention, in the area between the adjacent IDT electrodes or in the area between the IDT electrode and the grating reflector which are adjacent to each other, at positions apart from the crossing area of the electrode fingers toward the busbar side, there are provided the float dummy electrodes whose width size and separation sizes from the adjacent IDT electrodes or from the adjacent grating reflector are set so as to correspond to the arrangement pattern of the electrode fingers of the IDT electrodes and which are in the state of electrically floating from the other regions. This makes it possible to reduce a capacitive component generated between the IDT electrodes on both sides of the float dummy electrodes or between the IDT electrode and the grating reflector on both sides of the float dummy electrode while preventing an influence on the propagation of the elastic wave. Accordingly, it is possible to obtain an elastic wave device that is capable of suppressing deterioration in flatness of a frequency characteristic in a pass frequency band yet has excellent ESD resistance. Further, in another invention, at least one of the grating electrode fingers, of the grating reflector, adjacent to the IDT electrodes is in the state of electrically floating from the other regions. This makes it possible to obtain an elastic wave device that is capable of suppressing deterioration in flatness of the frequency characteristic in the pass frequency band yet has excellent ESD resistance.

### BRIEF DESCRIPTION OF THE DRAWINGS

Fig. 1 is a plane view showing an example of a longitudinal-mode resonant filter to which the elastic wave device of the present invention is applied;
Fig. 2 is an enlarged schematic view showing part of the filter;
Fig. 3 is an enlarged schematic view showing part of the filter;
Fig. 4 is an enlarged schematic view showing part of a conventional filter;
Fig. 5 is an enlarged schematic view showing part of the filter of the present invention;
Fig. 6 is a plane view showing another example of the filter of the present invention;
Fig. 7 is a plane view showing another example of the filter of the present invention;
Fig. 8 is a plane view showing another example of the filter of the present invention;
Fig. 9 is a plane view showing another example of the filter of the present invention;
Fig. 10 is a plane view showing another example of the filter of the present invention;
Fig. 11 is a plane view showing another example of the filter of the present invention;
Fig. 12 is a plane view showing another example of the filter of the present invention;
Fig. 13 is a plane view showing another example of the filter of the present invention;
Fig. 14 is a plane view showing another example of the filter of the present invention;
Fig. 15 is a plane view showing another example of the filter of the present invention;
Fig. 16 is a plane view showing another example of the filter of the present invention;
Fig. 17 is a plane view showing another example of the filter of the present invention; and
Fig. 18 is a plane view showing another example of the conventional filter.

### DETAILED DESCRIPTION OF THE PREFERRED EMBODIMENTS

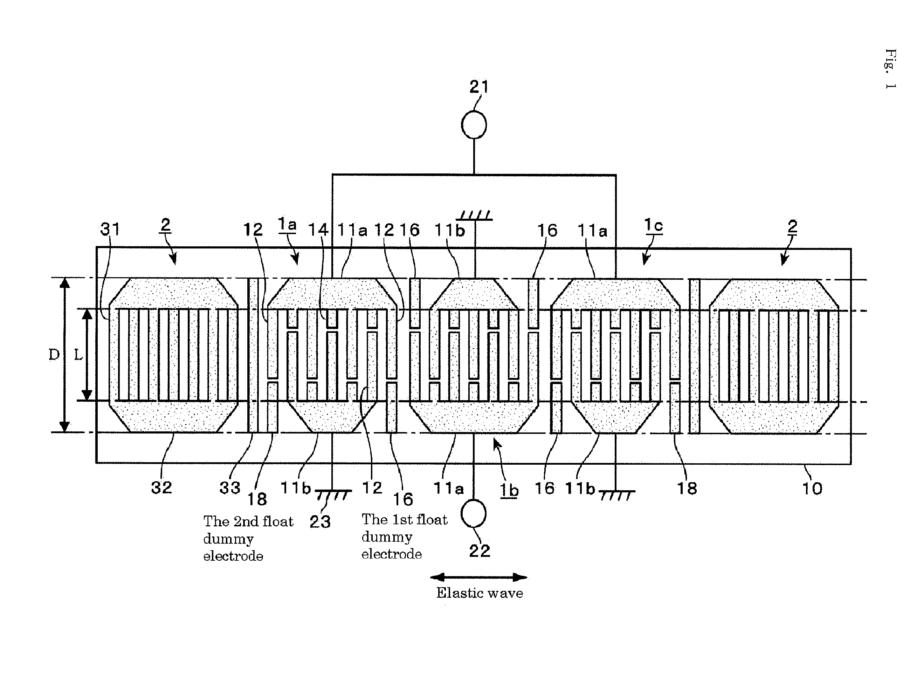

An example of an embodiment where the elastic wave device of the present invention is applied to a longitudinal-mode resonant filter will be described with reference to Fig. 1. This filter includes: a plurality of, for example, three IDT (Inter-Digital Transducer) electrodes 1 arranged along a propagation direction of an elastic wave; and grating reflectors 2 disposed to sandwich the IDT electrodes 1 from both sides. These IDT electrodes 1 and grating reflectors 2 are formed on a common substrate 10 having a piezoelectric property, such as quartz crystal, for instance.

The IDT electrodes 1 each include: a pair of busbars 11, 11 disposed apart from each other in a direction perpendicular to the propagation direction of the elastic wave; and a plurality of electrode fingers 12 extending in a comb shape from each of the pair of busbars toward the opposite busbar 11. In each of the IDT electrodes 1, one of the busbars 11, 11 is connected to one of an input port 21 and an output port 22 being signal ports, and the other one of the busbars 11, 11 is connected to a ground port 23. Regarding these busbars 11, 11, the busbars 11 connected to the input port 21 or the output port 22 are denoted by "11a" and the busbars 11 connected to the ground port 23 are denoted by "11b". The IDT electrodes 1 are disposed so that the busbars 11a and the busbars 11b are alternately arranged in a line along the propagation direction of the elastic wave. Therefore, on the substrate 10, regions different in potential (busbars 11a, 11b) are alternately arranged along the propagation direction of the elastic wave. For easier view of borders between the adjacent IDT electrodes 1, 1, in the busbars 11 a, 11b, corners of regions opposite regions to which the electrode fingers 12 are connected are obliquely cut out. Note that the cutout portions at end portions of these busbars 11a, 11b are exaggeratedly depicted large.

Let us call the direction perpendicular to the propagation direction of the elastic wave a front and rear direction and denote the IDT electrodes 1 by "1a", "1b", and "1c" in order from left to right along the propagation direction of the elastic wave, then the busbars 11a of the IDT electrodes 1a, 1c are connected to the input port 21, for instance, and the busbar 11a of the IDT electrode 1b is connected to the output port 22, for instance. An arrangement pattern of these IDT electrodes 1a, 1b, 1c is set so as to correspond to a length of a wavelength of the elastic wave propagating in this filter, the arrangement pattern being composed of: a size of a cycle unit composed of a width size of each of the electrode fingers 12 and a separation size between the electrode fingers 12, 12; and a separation size between the adjacent IDT electrodes 1, 1. Therefore, the IDT electrodes 1a, 1b, 1c are disposed so that this arrangement pattern is continuously formed along the propagation direction of the elastic wave. Here, since the IDT electrodes 1a, 1b, 1c have substantially the same structure, these IDT electrodes 1a, 1b, 1c will be described in detail, taking the left IDT electrode 1a as an example.

The IDT electrode 1a is structured so that a crossing width L with which the electrode fingers 12 extending from the busbar 11a (11b) and the electrode fingers 12 extending from the busbar 11b (11a) adjacently to the aforesaid electrode fingers 12 cross each other is shorter than an aperture length D being a size between the busbars 11a, 11b. Concretely, in extension areas of tips of the electrode fingers 12 extending from the busbar 11a toward the other busbar 11b, dummy electrode fingers 14 extending from the other busbar 11b toward the busbar 11a are disposed close to the tips of these electrode fingers 12. Similarly, in extension areas of tips of the electrode fingers 12 extending from the other busbar 11b toward the busbar 11a, dummy electrode fingers 14 extending from the busbar 11a toward the other busbar 11b are disposed close to the tips of these electrode fingers 12. Therefore, the electrode finger 12 and the dummy electrode finger 14 are arranged in a line in the direction perpendicular to the propagation direction of the elastic wave.

Here, assuming that in the IDT electrode 1a, the electrode finger 12 on the right (on a side adjacent to the IDT electrode 1b) is called a first end electrode finger, on an extension line (in an extension area) of the tip of the first end electrode finger 12, a first float dummy electrode 16 extending along the extension line is formed. Since the busbar 11b extends only up to a position of the electrode finger 12 that is located on the left side next to the first end electrode finger 12, the first float dummy electrode 16 is apart from the busbar 11b. That is, the first float dummy electrode 16 is in an electrically floating state and forms a float electrode.

When seen in the propagation direction of the elastic wave, the first float dummy electrode 16 is formed to extend from a position close to the tip of the first end electrode finger 12 up to an edge line, in the busbar 11b, opposite an edge line to which the electrode fingers 12 are connected. That is, as will be described later, the elastic wave generated in an excitation area of the elastic wave (area where the electrode fingers 12, 12 cross each other) leaks to an area where the busbar 11b is formed to propagate in this area toward left and right sides. Therefore, it can be said that the first float dummy electrode 16 is disposed so as to extend to a propagation area of the elastic wave, in an area deviating from the excitation area toward the busbar 11b.

The first float dummy electrode 16 is disposed so that its width size and its separation size from each of the electrode fingers 12, 12 of the IDT electrodes 1a, 1b on both sides of the float dummy electrode 16 become equal to a width size of each of the electrode fingers 12 and a separation size between the electrode fingers 12, 12. Therefore, an arrangement pattern of the first float dummy electrode 16 corresponds to an arrangement pattern of the electrode fingers 12. This first float dummy electrode 16 is not electrically connected to any of the IDT electrodes 1a, 1b, 1c, the input port 21, the output port 22, the ground port 23, and the grating reflectors 2, and thus is in a state of electrically floating from the other regions.

Further, assuming that in the IDT electrode 1a, the electrode finger 12 closest to the grating reflector 2 is called a second end electrode finger, a second float dummy electrode 18 extending along an extension line of the second end electrode finger 12 is disposed in an extension area of a tip of the second end electrode finger 12. The busbar 11b is disposed apart from the second end electrode finger 12. As for the second float dummy electrode 18, its width size, its length size, and its separation size from the electrode finger 12, of the IDT electrode 1a, adjacent to the second float dummy electrode 8 are set equal to those of the first float dummy electrode 16. Further, the second float dummy electrode 18, similarly to the first float dummy electrode 16, is disposed so as to extend up to the area deviating from the excitation area of the elastic wave in the direction perpendicular to the propagation direction of the elastic wave, that is, the area where the elastic wave leaking from the excitation area propagates (up to the area where the busbar 11b is formed). Similarly to the first float dummy electrode 16, the second float dummy electrode 18 is also in a state of electrically floating from the other regions.

The IDT electrodes 1b, 1c on the right of the IDT electrode 1a have the same structure as that of the IDT electrode 1a. Concretely, in the IDT electrode 1a, let us call a busbar 11a side to which the end electrode fingers 12, 12 are connected "a far side" and call a side toward the area where the float dummy electrodes 16, 18 are disposed "a near side", then at the left and right sides in the IDT electrode 1b, the first end electrode fingers 12, 12 are disposed to extend from the near-side busbar 11a toward the far side. On the far side of the first end electrode fingers 12, 12, the first float dummy electrodes 16, 16 are formed respectively.

Further, in the IDT electrode 1c, the first end electrode finger 12 extending from the far-side busbar 11a is disposed at the left side in the IDT electrode 1c, and the first float dummy electrode 16 is provided on the near side of the first end electrode finger 12. The second end electrode finger 12 extending from the far-side busbar 11 a is disposed at the right side in the IDT electrode 1c, and the second float dummy electrode 18 is formed on the near side of the second end electrode finger 12. Therefore, in this example, the float dummy electrodes 16 (18) are disposed on both sides of end portions of the busbar 11 b in each of the IDT electrodes 1a, 1b, 1c.

Next, the grating reflectors 2 will be described. The grating reflectors 2 each include: a plurality of grating electrode fingers 31 disposed to extend along the electrode fingers 12 and to be apart from each other in the propagation direction of the elastic wave; and a pair of grating busbars 32 disposed to connect one-side tips and the other-side tips of the grating electrode fingers 31 respectively. A width size of each of the grating electrode fingers 31 and a separation size between the grating electrode fingers 31, 31 are set equal to the width size of each of the electrode fingers 12 and the separation size between the electrode fingers 12, 12 in the IDT electrodes 1. Therefore, the grating reflectors 2 are each formed so as to correspond to the aforesaid arrangement pattern in the IDT electrodes 1.

Between the grating reflector 2 and the IDT electrode 1a and between the grating reflector 2 and the IDT electrode 1c, float reflectors 33 each being a line-shaped electrode extending in the direction perpendicular to the propagation direction of the elastic wave are disposed respectively. A width size of each of the float reflectors 33 is equal to the width size of the electrode finger 12. Further, when seen in the propagation direction of the elastic wave, the float reflectors 33 are each formed to extend between edge lines, in the pair of busbars 11a, 11b, opposite edge lines to which the electrode fingers 12, 12 are connected, and a separation size of the float reflectors 33 from the IDT electrodes 1a, 1c (second float dummy electrodes 18, 18) and from the grating reflectors 2 are set equal to the separation size between the electrode fingers 12, 12. Specifically, each of the float reflectors 33 is the single grating electrode finger 31, of the grating reflector 2, adjacent to the IDT electrode 1a (1c), with both tips thereof being separated from the grating busbars 32, 32. Similarly to the aforesaid float dummy electrodes 16, 18, the float reflectors 33 are also in a state of electrically floating from the other regions. Therefore, the three IDT electrodes 1, and the grating reflectors 2 and the float reflectors 33 on both sides of these IDT electrodes 1 are formed so that the aforesaid arrangement pattern is continuously formed along the propagation direction of the elastic wave.

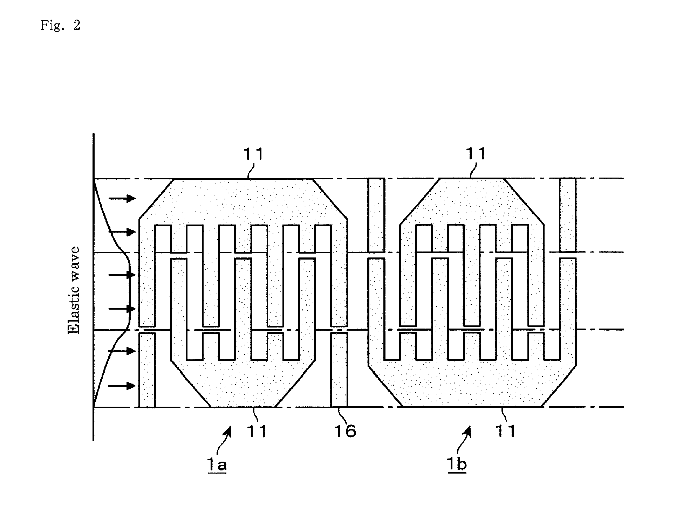

When an electric signal is input to the input port 21 in this filter, the elastic wave is generated in the crossing areas of the electrode fingers 12, 12 (excitation areas), and the elastic wave propagates to the left and right sides. The elastic wave spreads in the direction perpendicular to the propagation direction of the elastic wave as it propagates on the substrate 10, and as shown in Fig. 2, comes into a state of spreading between the edge lines, in the busbars 11a, 11b, opposite the edge lines to which the electrode fingers 12, 12 are connected. Then, when reaching the grating reflector 2, the elastic wave is reflected on the grating reflector 2 to reciprocate between the grating reflectors 2, 2 via the area where the three IDT electrodes 1 are disposed. At this time, bulk radiation or the like of the elastic wave is suppressed in the first float dummy electrodes 16, the second float dummy electrodes 18, and the float reflectors 33 since the first float dummy electrodes 16, the second float dummy electrodes 18, and the float reflectors 33 are disposed to be in the same pattern as the arrangement pattern of the electrode fingers 12, 12. Further, since the float dummy electrodes 16, 18 are formed up to the areas where the busbars 11a, 11b are disposed, a propagation speed of the elastic wave in the areas where the busbars 11a, 11b are formed is equal to that in the aforesaid crossing areas. Therefore, when the elastic wave propagating while spreading between the busbars 11a, 11b is taken out as an electric signal from the output port 22, its spuriousness is reduced and its frequency characteristic in a pass frequency band has good flatness. Note that the filter is schematically shown in Fig. 2.

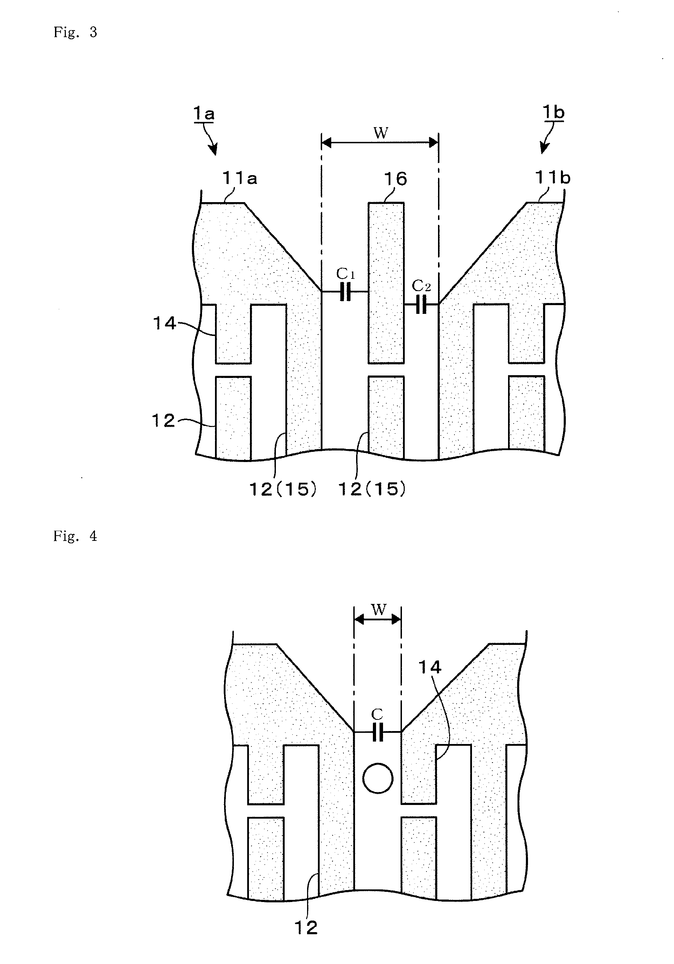

Since the busbars 11a, 11b adjacent to each other are different in potential as previously described, capacitive components C try to be generated in these busbars 11a, 11b. Fig. 3 shows an enlarged view of such capacitive components C in an area between the IDT electrodes 1a, 1b. Here, since the first float dummy electrode 16 is interposed between these busbars 11a, 11b, the capacitive components C are formed with the first float dummy electrode 16 interposed therebetween. Therefore, the two capacitive components C1, C2 are connected in series via the first float dummy electrode 16 between the busbars 11 a, 11b, so that a total value of the capacitive components C1, C2 is 1/2 compared with a value (of the capacitive component C) in a case where the first float dummy electrode 16 is not provided. Fig. 4 schematically shows the capacitive component C generated in the aforesaid filter shown in Fig. 18 (the case where the first float dummy electrode 16 is not provided).

Further, as is seen from Fig. 3 and Fig. 4, when the first float dummy electrode 16 is disposed between the busbars 11a, 11b, a size W between the busbars 11a, 11b is wider than that in the case where the first float dummy electrode 16 is not provided, while the aforesaid arrangement pattern is formed between the IDT electrodes 1a, 1b. Accordingly, the total value of the capacitive components C1, C2 is still smaller than 1/2 of the capacitive component C in Fig. 4.

In a near-side area between the IDT electrodes 1a, 1b, capacitive components C1, C2 are also formed between the busbars 11a, 11b, with the first float dummy electrode 16 therebetween, and between the IDT electrodes 1b, 1c, such capacitive components C1, C2 are similarly formed with the first float dummy electrodes 16, 16 therebetween.

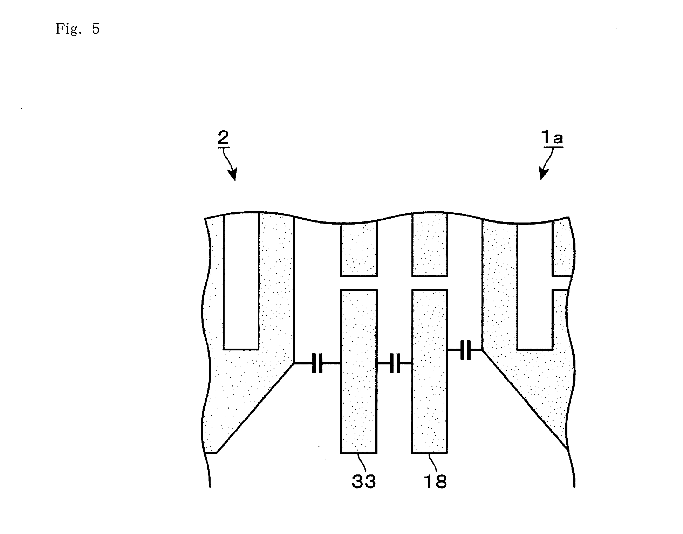

Further, between the IDT electrode 1a (1c) and the grating reflector 2, the capacitive components C try to be generated between the near-side grating busbar 32 and the near-side busbar 11b, for instance, as in the above-described example. However, as shown in Fig. 5, since the second float dummy electrode 18 and the float reflector 33 are disposed between these grating busbar 32 and busbar 11b, three capacitive components C1, C2, C3 are formed in series via the second float dummy electrode 18 and the float reflector 33. Further, a size between these grating busbar 32 and busbar 11b is larger than that in the case where the second float dummy electrode 18 and the float reflector 33 are not provided (Fig. 18 described above). Therefore, a total value of the three capacitive components C1, C2, C3 is smaller than 1/3 of the capacitive component C generated between the grating reflector 2 and the IDT electrode 1 in Fig. 18.

Therefore, even when a high voltage of ESD (Electrostatic Discharge) or the like is applied to this filter, an electrostatic discharge damage is prevented between the adjacent IDT electrodes 1, 1 or between the IDT electrode 1 and the grating reflector 2 which are adjacent to each other. Further, even when the electrostatic discharge damage occurs in the filter due to the aforesaid high voltage, a value of a flowing current becomes small because the capacitive components C between the adjacent IDT electrodes 1, 1 and between the IDT electrode 1 and the grating reflector 2 which are adjacent to each other are small, as compared with the filter in Fig. 18. Note that part of the filter is shown in an enlarged manner also in Fig. 5.

Further, in the filter in Fig. 18, as shown by the mark "o" in Fig. 4, the elastic wave is generated between the electrode finger 12 and the dummy electrode finger 14 in the adjacent IDT electrodes 1, 1, so that the elastic wave becomes a cause of unnecessary longitudinal-mode spuriousness. On the other hand, in the filter in Fig. 1, since the first float dummy electrode 16 is disposed in the area between these electrode finger 12 and dummy electrode finger 14 and these electrode finger 12 and dummy electrode finger 14 are greatly apart from each other as described above, the generation of the elastic wave in this area is prevented.

According to the above-described embodiment, at positions apart from the crossing area of the electrode fingers 12, 12 toward the busbar 11, the first float dummy electrodes 16, 16 and the second float dummy electrode 18 are provided between the adjacent IDT electrodes 1, 1 and between the IDT electrode 1 and the grating reflector 2 which are adjacent to each other, respectively, and the float reflector 33 is disposed between the IDT electrode 1 and the grating reflector 2 which are adjacent to each other. These float dummy electrodes 16, 18 and float reflectors 33 are in the state of electrically floating from the other regions, and these float dummy electrodes 16, 18 and float reflectors 33 are formed so as to correspond to the arrangement pattern in the IDT electrodes 1. Therefore, it is possible to reduce the capacitive component C generated between the adjacent IDT electrodes 1, 1 and between the IDT electrode 1 and the grating reflector 2 which are adjacent to each other, while reducing the influence on the elastic wave, compared with the case where these float dummy electrodes 16, 18 and float reflectors 33 are not provided. Therefore, even when the high voltage of static electricity or the like is applied between, for example, the input port 21 or the output port 22 and the ground port 23, it is possible to prevent the current passage (electrostatic discharge damage) between the input port 21 or the output port 22 and the ground port 23 while preventing deterioration in flatness of the frequency characteristic in the pass frequency band. This makes it possible to obtain an elastic wave device excellent in ESD (Electrostatic Discharge) resistance. Further, providing the float dummy electrodes 16, 18 and the float reflectors 33 reduces the capacitive components C generated between the adjacent IDT electrodes 1, 1 and between the IDT electrode 1 and the grating reflector 2 which are adjacent to each other. Therefore, even when the current passes between the input port 21 or the output port 22 and the ground port 23 due to the occurrence of static electricity or the like, it can be said that resistance against the electrostatic discharge damage is improved due to a reduced current value, compared with the case where the float dummy electrodes 16, 18 and the float reflectors 33 are not provided.

Further, since the float dummy electrodes 16, 18 are formed up to the area where the busbar 11a (11b) are formed, it is possible to reduce a difference in speed of the elastic wave between this area and the crossing area of the electrode fingers 12, 12, and thus spuriousness is reduced, which makes it possible to obtain a characteristic with high flatness. Furthermore, providing the first float dummy electrode 16 makes it possible to prevent the generation of the elastic wave between the adjacent electrode finger 12 and dummy electrode finger 14 in the IDT electrodes 1, 1, so that the occurrence of unnecessary longitudinal-mode spuriousness is prevented, which makes it possible to obtain a characteristic excellent in flatness.

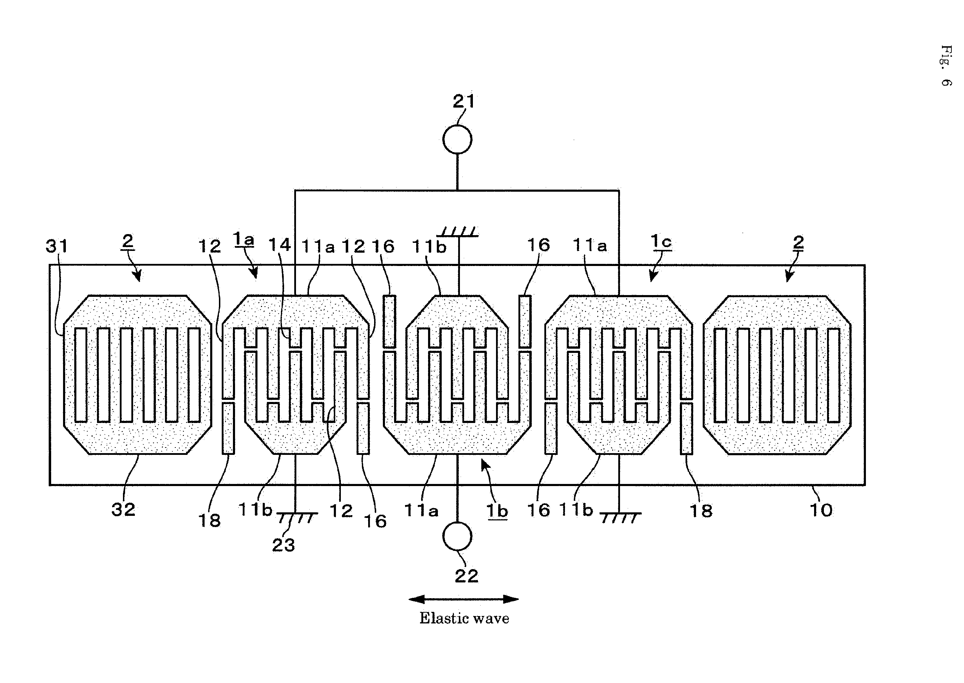

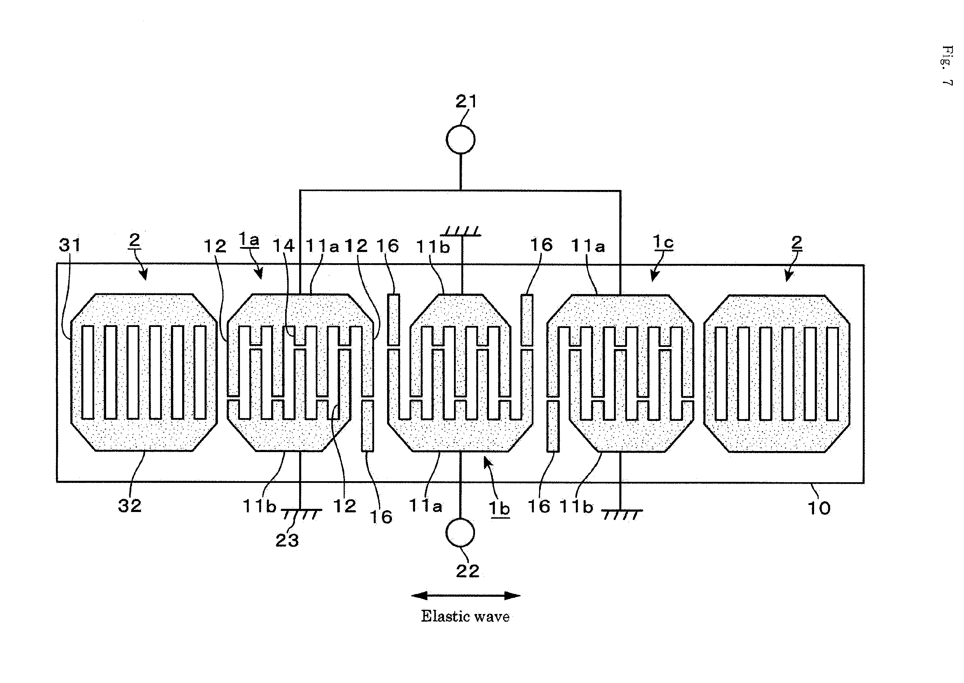

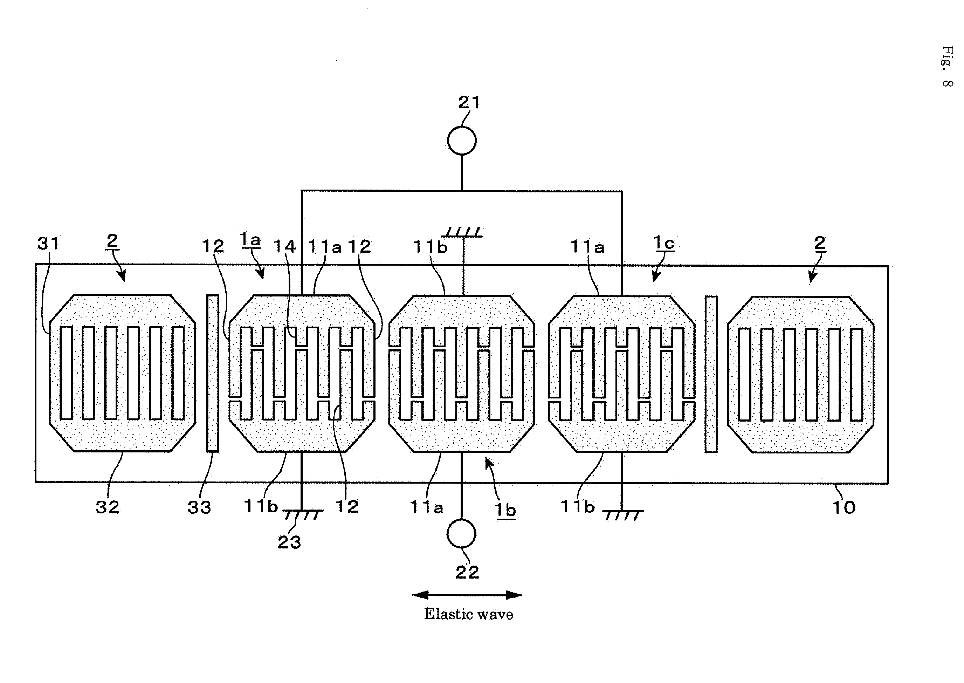

In the above-described example, the float reflectors 33 are provided in the respective areas between the IDT electrodes 1 and the grating reflectors 2 which are adjacent to each other, but the float reflector 33 may be disposed only on the left side or the right side, or the float reflector 33 need not be provided as shown in Fig. 6. Further, the second float dummy electrode 18 may also be provided only on the left side or the right side, or need not be provided as shown in Fig. 7. Furthermore, the first float dummy electrodes 16 are disposed on the near side and the far side between the adjacent IDT electrodes 1, 1, but the first float dummy electrodes 16 may be disposed only on the near side or the far side, or the first float dummy electrode 16 may be disposed in at least one place between the adjacent IDT electrodes 1,1. Further, without the first float dummy electrode 16 and the second float dummy electrode 18 being disposed, the float reflector 33 may be disposed at least in one of the areas between the adjacent IDT electrodes 1 and grating reflectors 2. Fig. 8 shows an example where the float dummy electrodes 16, 18 are not disposed and the float reflectors 33, 33 are disposed in the areas between the IDT electrodes 1 and grating reflectors 2 which are adjacent to each other.

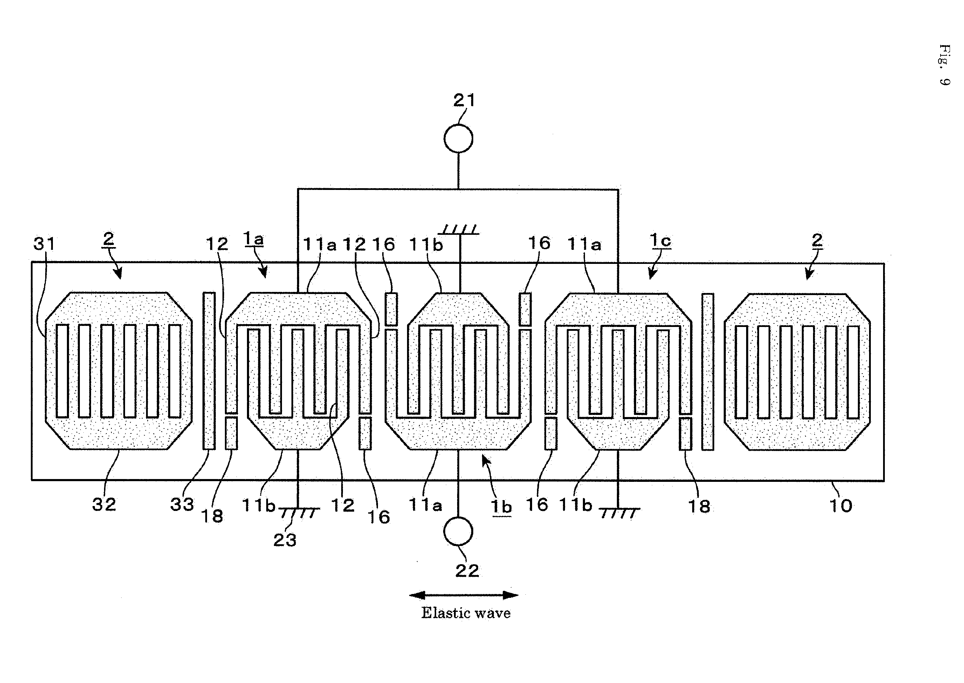

Further, as shown in Fig. 9, without the dummy electrode fingers 14 being disposed, the tips of the electrode fingers 12 extending from the one-side busbar 11 a (11b) may extend up to positions close to the other busbar 11b (11a) so that the aperture length D and the crossing width L become equal to each other. Fig. 9 shows an example where in such a case, the first float dummy electrodes 16, the second float dummy electrodes 18, and the float reflectors 33 are provided. In this case, in areas apart from the tips of the end electrode fingers 12, 12, the float dummy electrodes 16, 18 are formed so as to overlap with the area where the busbar 11a (11 b) are formed when seen in the propagation direction of the elastic wave. In this case as well, when the elastic wave is generated in the crossing area of the electrode fingers 12, 12, this elastic wave propagates while spreading up to the areas where the busbars 11a, 11b are formed. Therefore, the difference in speed of the elastic wave between these areas and the crossing areas is reduced owing to the float dummy electrodes 16, 18.

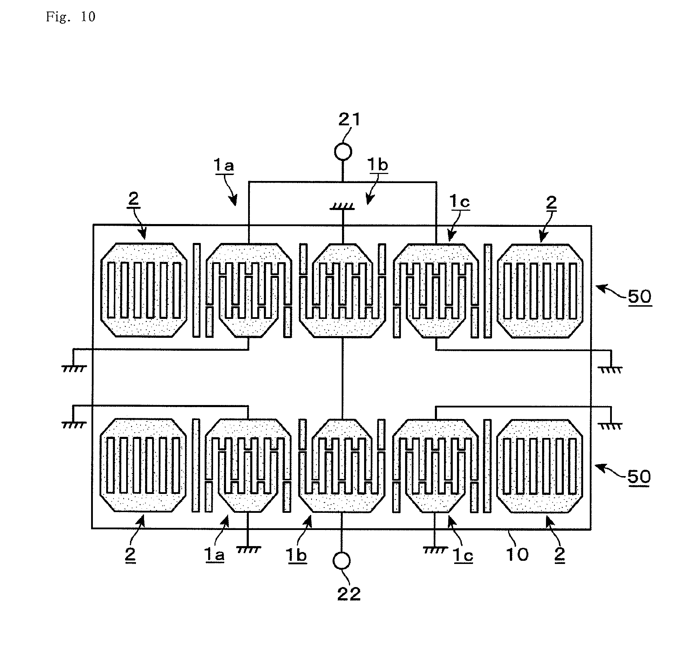

Alternatively, as shown in Fig. 10, the aforesaid filters may be connected in cascade. Fig. 10 shows an example where two filters each being the same as that shown in Fig. 1 are connected in cascade, and the filters 50 each including the three IDT electrodes 1 and the grating reflectors 2, 2 disposed on both sides of these IDT electrodes 1 are arranged on the near side and the far side on the common substrate 10. Then, the near-side busbar 11 of the IDT electrode 1b of the far-side filter 50 and the far-side busbar 11 of the IDT electrode 1b of the near-side filter 50 are connected to each other, and the far-side busbars 11 of the far-side IDT electrodes 1a, 1c and the near-side busbar 11 of the IDT electrode 1b of the near-side filter 50 are connected to the input port 21 and the output port 22 respectively.

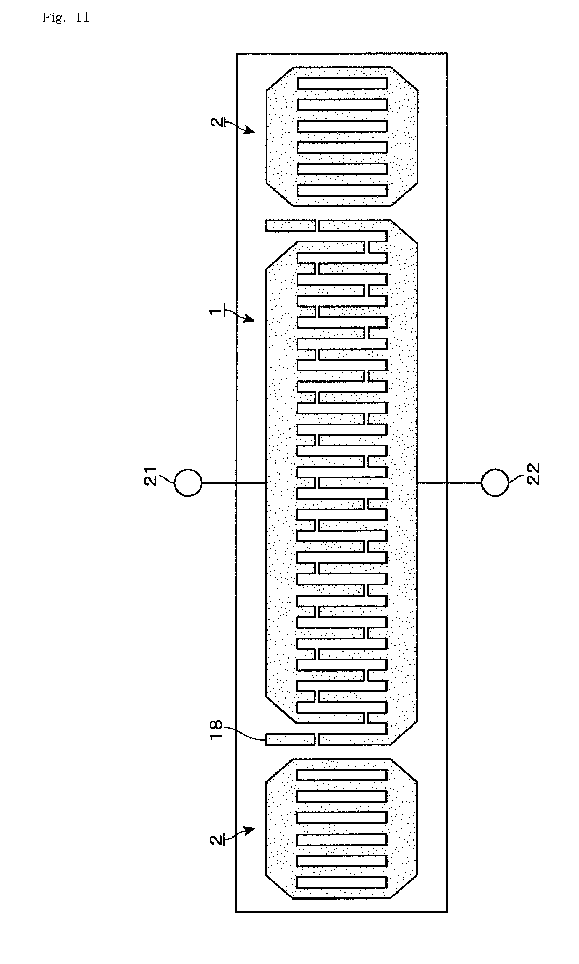

In the above-described examples, the examples where the three IDT electrodes 1 are arranged are described, but the number of the IDT electrodes 1 may be two, or four or more. Alternatively, as shown in Fig. 11, the grating reflectors 2, 2 may be disposed on both sides of the single IDT electrode 1 to form an elastic wave resonator. Then, the second float dummy electrode 18 may be provided at least in one of the areas between the IDT electrode 1 and the grating reflectors 2, or in addition to or instead of the second float dummy electrode 18, the float reflector 33 may be disposed in at least one of the areas between the IDT electrode 1 and the grating reflectors 2.

Further, the present invention is applied to devices including the aforesaid vertical-mode resonant filter and elastic wave resonator, for example, to an elastic wave device, such as a duplexer, in which the two IDT electrodes 1, 1 are adjacently disposed, and an elastic wave device in which the IDT electrode 1 and the grating reflector 2 are adjacently disposed.

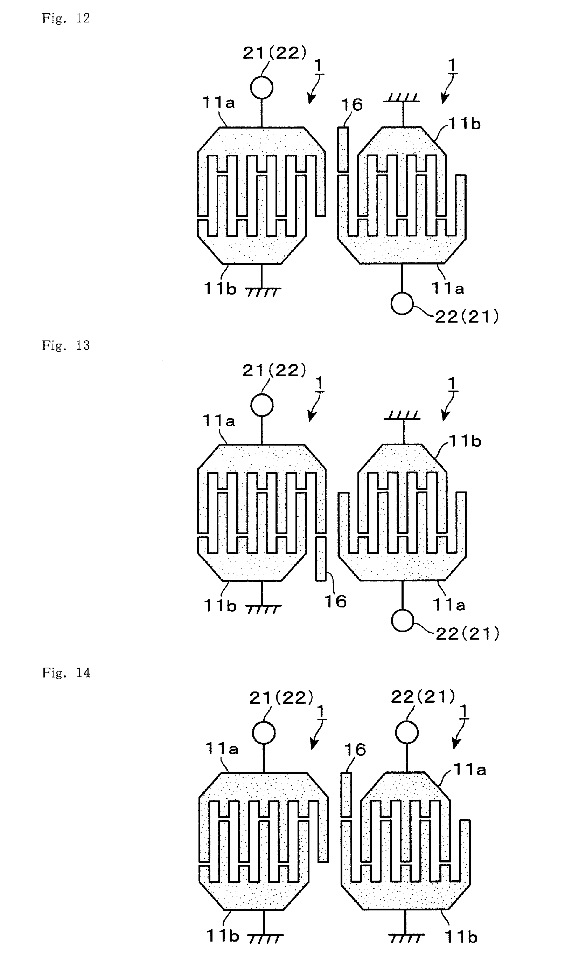

When the first float dummy electrode 16 is disposed only on the near side or the far side between the adjacent IDT electrodes 1, 1 as described above, the first float dummy electrode 16 is interposed between the busbars 1 1a, 11b different in potential. Concretely, as shown in Fig. 12 and Fig. 13, when the busbars 11a connected to the input port 21 or the output port 22 and the busbars 11b connected to the ground port 23 are alternately disposed in a line along the propagation direction of the elastic wave, the first float dummy electrode 16 may be disposed on one side between these busbars 11a, 11b. Alternatively, as shown in Fig. 14, when the busbar 11 a connected to the input port 21 and the busbar 11 a connected to the output port 22 are disposed in a line along the propagation direction of the elastic wave and the busbars 11b, 11b connected to the ground port 23 are disposed in a line along the propagation direction of the elastic wave, the first float dummy 16 may be disposed between the busbars 11a, 11a.

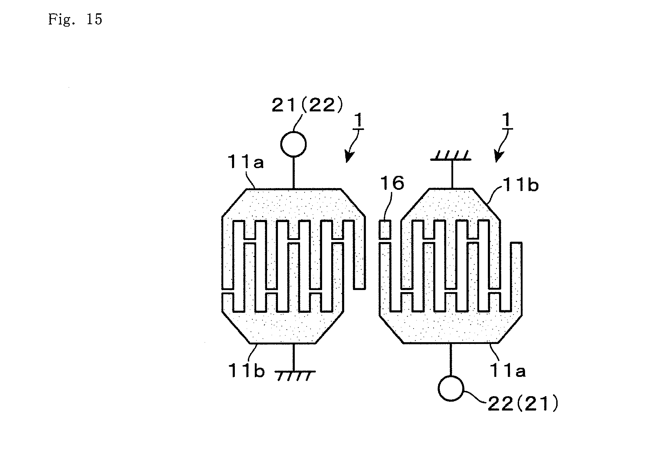

Further, the float dummy electrodes 16, 18 are disposed to extend from the positions close to the end electrode fingers 12, 12 up to the area where the busbar 11a (11b) are formed, but as shown in Fig. 15, the float dummy electrodes each may be formed to extend only in the area close to the end electrode fingers 12, 12. In this case as well, the difference in speed of the elastic wave between the areas where the float dummy electrodes 16, 18 are disposed and the crossing area of the electrode fingers 12, 12 is reduced. At this time, as for the IDT electrode 1 in which the float dummy electrodes 16, 18 are disposed, the busbar 11 on the float dummy electrodes 16, 18 side is disposed apart from the extension areas of the float dummy electrodes 16, 18 as previously described. Note that Fig. 12 to Fig. 15 show part of the filters in an enlarged manner.

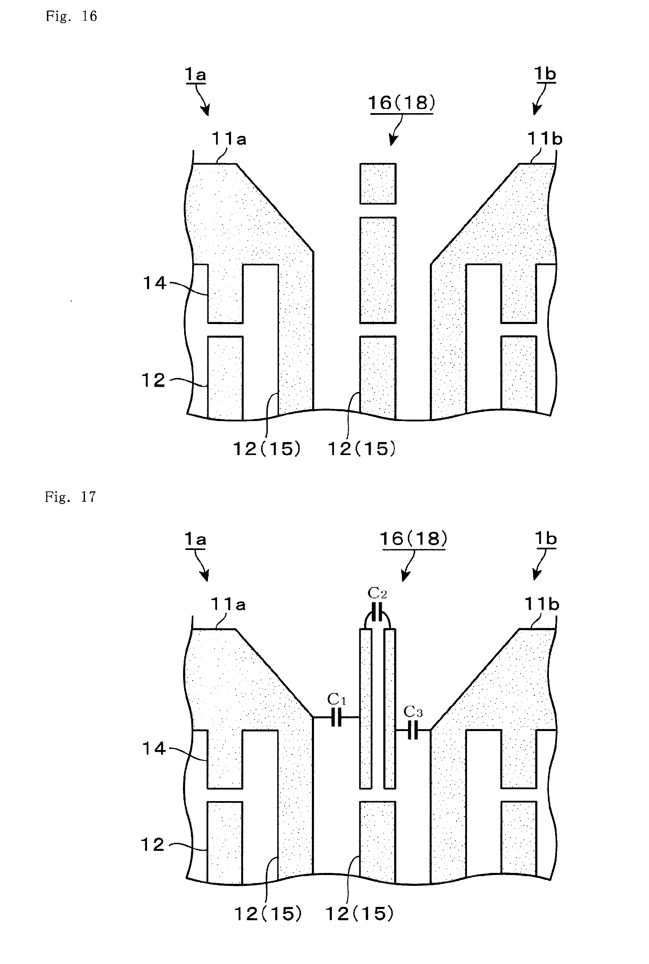

Here, the float dummy electrode 16 (18) may be divided into a plurality of parts, for example, into two parts in a length direction as shown in Fig. 16, or may be divided in a plurality of parts, for example, into two parts in the propagation direction of the elastic wave as shown in Fig. 17. When the float dummy electrode 16 (18) is disposed as in Fig. 17, the capacitive components C 1 to C3 are connected in series between the busbars 11a, 11b, which makes it possible to further reduce the capacitive component C between the busbars 11 a, 11b. In these cases as well, the float dummy electrode 16 (18) is formed so as to correspond to the aforesaid arrangement pattern. Further, the float reflectors 33 are disposed one per one area between the IDT electrode 1 and the grating reflector 2 which are adjacent to each other, but may be disposed two or three per one area.

Instead of quartz crystal, a material forming the aforesaid substrate 10 may be a material having a piezoelectric property such as LiTaO₃ (lithium tantalate) or LiNbO₃ (lithium niobate), may be a substrate in which one layer of a thin film of any of these piezoelectric materials or more is stacked on a plate not having a piezoelectric property such as, for example, glass, may be a laminate of piezoelectric thin films, or the like.
There is provided an elastic wave device that is capable of suppressing deterioration in flatness of a frequency characteristic in a pass frequency band yet has excellent ESD resistance. At positions apart from a crossing area of electrode fingers 12, 12 toward a busbar 11, first float dummy electrodes 16, 16 and a second float dummy electrode 18 are provided between adjacent IDT electrodes 1, 1 and between the IDT electrode 1 and a grating reflector 2 which are adjacent to each other. These float dummy electrodes 16, 18 are in a state of electrically floating from other regions, and these float dummy electrodes 16, 18 are formed so as to correspond to an arrangement pattern of the electrode fingers 12 in the IDT electrode 1.

## Claims

1. An elastic wave device comprising:
a plurality of IDT electrodes arranged apart from each other along a propagation direction of an elastic wave; and grating reflectors sandwiching the plural IDT electrodes from both sides in terms of the propagation direction of the elastic wave, the IDT electrodes and the grating reflectors being formed on a common piezoelectric substrate,
wherein the plural IDT electrodes each comprise: a pair of busbars connected to one and the other of a signal port and a ground port respectively; and electrode fingers extending in a comb shape from each of the busbars toward the opposite busbar, and an arrangement pattern of the electrode fingers in each of the IDT electrodes and a separation size between the adjacent IDT electrodes are set in order for an arrangement pattern of the electrode fingers in the IDT electrodes to be continuously formed along the propagation direction of the elastic wave,
wherein the grating reflectors each comprise: a plurality of grating electrode fingers extending along a length direction of the electrode fingers and disposed apart from each other in the propagation direction of the elastic wave; and grating busbars connecting one-side tips and the other-side tips of the grating electrode fingers respectively, and an arrangement of the grating electrode fingers and a separation size of each of the grating reflectors from the adjacent IDT electrode correspond to the arrangement pattern,
wherein, assuming that in one IDT electrode out of the two adjacent IDT electrodes, the electrode finger adjacent to the other IDT electrode is called a first end electrode finger, an end portion closer to the other IDT electrode in the busbar opposite the busbar connected to the first end electrode finger, out of the pair of the busbars of the one IDT electrode, is apart from an extension area of a tip of the first end electrode finger toward the one IDT electrode side,
wherein a first float dummy electrode extending in a direction perpendicular to the propagation direction of the elastic wave is formed in the extension area to prevent an electrostatic discharge damage between regions different in potential between the one IDT electrode and the other IDT electrode, and
wherein a width size of the first float dummy electrode and separation sizes of the first float dummy electrode from the IDT electrodes on both sides of the first float dummy electrode correspond to the arrangement pattern, and the first float dummy electrode is in a state of electrically floating from the plural IDT electrodes, the signal port, the ground port, and the grating reflectors.

2. The elastic wave device according to claim 1,
wherein, assuming that in the IDT electrode adjacent to the grating reflector, the electrode finger adjacent to the grating reflector is called a second end electrode finger, an end portion closer to the grating reflector in the busbar opposite the busbar connected to the second end electrode finger, out of the pair of busbars of the adjacent IDT electrode, is apart from an extension area of a tip of the second end electrode finger toward the adjacent IDT electrode side.
wherein a second float dummy electrode extending in the direction perpendicular to the propagation direction of the elastic wave is formed in the extension area of the second end electrode finger to prevent an electrostatic discharge damage between the grating reflector and the adjacent IDT electrode, and
wherein a width size of the second float dummy electrode and separation sizes of the second float dummy electrode from the adjacent IDT electrode and from the grating reflector correspond to the arrangement pattern, and the second float dummy electrode is in a state of electrically floating from the plural IDT electrodes, the signal port, the ground port, the grating reflectors, and the first float dummy electrode.

3. The elastic wave device according to claim 1,
wherein the grating busbars, instead of connecting the one-side tips and the other-side tips of the grating electrode fingers, connect the one-side tips and the other-side tips of the grating electrode finger at an end opposite the IDT electrode up to the grating electrode finger next to at least one grating electrode finger on the IDT electrode side, to release both tips of the at least one grating electrode finger from the grating busbars and make the at least one grating electrode finger form a float reflector.

4. The elastic wave device according to claim 1,
wherein in each of the plural IDT electrodes, dummy electrode fingers extending from each of the pair of busbars to face tips of the electrode fingers extending from the opposite busbar are provided to make a crossing width smaller than an aperture length in terms of the propagation direction of the elastic wave, the crossing width being a width with which the electrode fingers extending adjacently to each other from one busbar and from the other busbar out of the pair of busbars cross each other, and the aperture length being a size between the pair of busbars,
wherein the first float dummy electrode is formed to extend from a position close to the tip of the first end electrode finger up to an edge line opposite an edge line to which the electrode fingers are connected in the busbar facing the busbar to which the first end electrode finger is connected, when seen in the propagation direction of the elastic wave.

5. The elastic wave device according to claim 4,
wherein the second float dummy electrode is formed to extend from a position close to the tip of the second end electrode finger to the edge line opposite the edge line to which the electrode fingers are connected in the busbar facing the busbar to which the second end electrode finger is connected, when seen in the propagation direction of the elastic wave.

6. The elastic wave device according to claim 1,
wherein the busbar to which the signal port is connected in the one IDT electrode and the busbar to which the ground port is connected in the other IDT electrode are disposed in a line along the propagation direction of the elastic wave, and
wherein the first float dummy electrode is provided in an area, of the other IDT electrode, adjacent to the one IDT electrode, in addition to the area, of the one IDT electrode, adjacent to the other IDT electrode.

7. The elastic wave device according to claim 1,
wherein the number of the IDT electrodes is three or more,
wherein in the IDT electrodes, the busbars to which the signal port is connected and the busbars to which the ground port is connected are alternately disposed in a line along the propagation direction of the elastic wave, and
wherein, as for one IDT electrode and the other IDT electrode adjacent to each other out of the IDT electrodes, in the one IDT electrode, the first float dummy electrode is disposed in an area adjacent to the other IDT electrode, and in the other IDT electrode, the first float dummy electrode is disposed in an area adjacent to the one IDT electrode.

8. The elastic wave device according to claim 7,
wherein the second float dummy electrodes are provided in respective areas between the grating reflectors and the IDT electrodes adjacent to the grating reflectors.

9. The elastic wave device according to claim 7,
wherein the float reflectors are provided in the respective areas between the IDT electrodes and the grating reflectors.

10. An elastic wave device comprising:
an IDT electrode formed on a piezoelectric substrate and including: a pair of busbars each connected to a signal port or a ground port; and electrode fingers extending in a comb shape from each of the busbars toward the opposite busbar; and
a grating reflector formed on the piezoelectric substrate to be apart from the IDT electrode in a propagation direction of an elastic wave, and including: a plurality of grating electrode fingers extending along a length direction of the electrode fingers and disposed apart from each other in the propagation direction of the elastic wave; and grating busbars connecting one-side tips and the other-side tips of the grating electrode fingers,
wherein, in the IDT electrode and the grating reflector, an arrangement pattern of the electrode fingers, an arrangement pattern of the grating electrode fingers, and a separation size between the IDT electrode and the grating reflector are set in order for an arrangement pattern of the electrode fingers in the IDT electrode to be continuously formed along the propagation direction of the elastic wave,
wherein, assuming that the electrode finger adjacent to the grating reflector is called a second end electrode finger, an end portion closer to the grating reflector in the busbar opposite the busbar connected to the second end electrode finger, out of the pair of busbars of the IDT electrode, is apart from an extension area of the second end electrode finger toward the IDT electrode,
wherein a second float dummy electrode extending in a direction perpendicular to the propagation direction of the elastic wave is formed in the extension area to prevent an electrostatic discharge damage between the grating reflector and the IDT electrode, and
wherein a width size of the second float dummy electrode and separation sizes of the second float dummy electrode from the IDT electrode and from the grating reflector correspond to the arrangement pattern, and the second float dummy electrode is in a state of electrically floating from the IDT electrode, the signal port, the ground port, and the grating reflector.

11. An elastic wave device comprising:
an IDT electrode formed on a piezoelectric substrate and including: a pair of busbars each connected to a signal port or a ground port; and electrode fingers extending in a comb shape from each of the busbars toward the opposite busbar; and
a grating reflector formed on the piezoelectric substrate to be apart from the IDT electrode in a propagation direction of an elastic wave, and including: a plurality of grating electrode fingers extending along a length direction of the electrode fingers and disposed apart from each other in the propagation direction of the elastic wave; and grating busbars connecting one-side tips and the other-side tips of at least the grating electrode finger located second from an IDT electrode-side end up to the grating electrode finger at an end portion opposite the IDT electrode,
wherein, in the IDT electrode and the grating reflector, an arrangement pattern of the electrode fingers, an arrangement pattern of the grating electrode fingers, and a separation size between the IDT electrode and the grating reflector are set in order for an arrangement pattern of the electrode fingers in the IDT electrode to be continuously formed along the propagation direction of the elastic wave, and
wherein the grating electrode finger disposed apart from the grating busbar is in a state of electrically floating from the IDT electrode, the signal port, the ground port, and other regions of the grating reflector.
